(19) Europäisches Patentamt
European Patent Office
Office européen des brevets

(11) **EP 1 777 532 A1**

(12) **EUROPÄISCHE PATENTANMELDUNG**

(43) Veröffentlichungstag:
**25.04.2007 Patentblatt 2007/17**

(51) Int Cl.:
*G01R 29/10* (2006.01)    *G01R 31/28* (2006.01)
*B60R 25/00* (2006.01)

(21) Anmeldenummer: **05022703.2**

(22) Anmeldetag: **18.10.2005**

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(71) Anmelder: **Delphi Technologies, Inc.**
**Troy, MI 48007 (US)**

(72) Erfinder:
• **Hildebrand, Carsten**
  **42115 Wuppertal (DE)**
• **Ioffe, Alexander, Dr.**
  **53229 Bonn (DE)**

(74) Vertreter: **Manitz, Finsterwald & Partner GbR**
**Postfach 31 02 20**
**80102 München (DE)**

(54) **Prüfverfahren und Treibereinrichtung für eine Antenne**

(57) Die Erfindung betrifft ein Prüfverfahren für eine Antenne, bei dem eine Spannung mit variierender Frequenz an die Antenne angelegt wird und frequenzabhängig die Amplitude des in Antwort darauf fließenden Stromes gemessen wird. Zur Feststellung der Funktionstüchtigkeit und/oder der Lage und/oder des Aufbaus der Antenne wird die Frequenzabhängigkeit der Amplitude des Stromes oder wenigstens ein daraus abgeleiteter Parameter ausgewertet. Die Erfindung betrifft weiterhin eine Treibereinrichtung zur Durchführung eines erfindungsgemäßen Verfahrens und einer Antenne mit einer erfindungsgemäßen Treibereinrichtung.

EP 1 777 532 A1

**Beschreibung**

Die Erfindung betrifft ein Prüfverfahren und eine Treibereinrichtung für eine Antenne, insbesondere eine Antenne zur Erzeugung eines Magnetfeldes, und die Verwendung eines solchen Verfahrens bzw. einer solchen Treibereinrichtung für ein drahtloses Zugangs- und/oder Berechtigungssystem, insbesondere bei Kraftfahrzeugen.

Magnetfelderzeugende Antenneneinrichtungen sind zum Beispiel in Zugangs- und/oder Berechtigungssystemen vorgesehen, um Signale an ein einen Schlüssel ersetzendes Element zu senden bzw. von einem einen Schlüssel ersetzenden Element zu empfangen. Insbesondere werden diese Systeme im automobilen Bereich eingesetzt (keyless car application).

Ein solches Sicherheitssystem ist in EP 1 454 807 A1 beschrieben. Um den korrekten Anschluss und die Funktionstüchtigkeit der Antenne zu prüfen, wird dort die Antenne mit einer Gleichspannung und/oder einem Gleichstrom beaufschlagt.

In DE 198 20 207 A1 wird eine Änderung der Induktivität der Antenne festgestellt, die zum Beispiel durch den Ausbau oder die Manipulation einzelner Komponenten hervorgerufen wird. Außerdem kann überprüft werden, ob die Antenne noch in ihrer Sollposition liegt oder nicht. Dazu wird ein Signal bei einer einzelnen angelegten Frequenz ausgewertet.

Eine Änderung zum Beispiel der Lage der Antenne oder eine Manipulation der Antenne muss aber bei der ausgewählten Frequenz nicht notwendigerweise zu einer Signaländerung führen.

Aufgabe der vorliegenden Erfindung ist es, ein Prüfverfahren für eine Antenne und eine Treibereinrichtung für eine Antenne anzugeben, mit denen eine Überprüfung der Antenne mit größerer Verlässlichkeit möglich ist.

Diese Aufgabe wird mit einem Prüfverfahren mit den Merkmalen des Anspruchs 1 bzw. eine Treibereinrichtung mit den Merkmalen des Anspruchs 7 gelöst. Anspruch 12 ist auf eine Antenneneinrichtung mit einer erfindungsgemäßen Treibereinrichtung und Anspruch 13 auf die Verwendung einer erfindungsgemäßen Treibereinrichtung, einer erfindungsgemäßen Antenneneinrichtung oder eines erfindungsgemäßen Verfahrens für ein drahtloses Zugangs- und/oder Berechtigungssystem, insbesondere bei Kraftfahrzeugen, gerichtet. Unteransprüche sind auf bevorzugte Ausgestaltungen gerichtet.

Bei dem erfindungsgemäßen Prüfverfahren für eine Antenne wird eine Spannung mit variierender Frequenz an die Antenne angelegt und die Amplitude des in Antwort darauf fließenden Stromes frequenzabhängig gemessen. Die Frequenzabhängigkeit der Amplitude des Stromes oder mindestens ein daraus abgeleiteter Parameter werden ausgewertet, um die Funktionstüchtigkeit und/oder die Lage und/oder den Aufbau der Antenne zu prüfen.

Bei einem Vergleich der gemessenen Frequenzabhängigkeit der Amplitude des Stroms mit einem Referenzverlauf kann gegebenenfalls eine Abweichung festgestellt werden und so auf einen Fehler oder eine Änderung der Antenne zurückgeschlossen werden. Der Referenzverlauf der Amplitude des Stromes kann zum Beispiel im Rahmen einer Eichmessung festgelegt werden.

Eine Abweichung kann als Trigger für eine Warnung über einen Fehler dienen oder verwendet werden, um zum Beispiel den Antennenstrom so nachzujustieren, dass das gewünschte Magnetfeld dennoch anliegt.

Außerdem lassen sich Abweichungen im Aufbau feststellen, wenn zum Beispiel Leitungsquerschnitt oder Abstand der Wicklungen nicht einer Referenzantenne entsprechen.

Das erfindungsgemäße Verfahren kann auch verwendet werden, um Abweichungen zweier nominal gleicher Antennen feststellen zu können, die zum Beispiel durch unterschiedliche Lage der Antennendrähte im jeweiligen Fahrzeug hervorgerufen werden können.

Die Variation der Frequenz kann entweder durch eine Steuerung automatisch bewirkt werden oder durch einen Benutzer vorgenommen werden.

Bei einer Manipulation der Antenne oder einer Abweichung der Einstellung, insbesondere der Lage, der Antenne ändert sich in der Regel die Induktivität des Systems. Zum Beispiel ist bei einer Antenne, die in einem Kraftfahrzeug verlegt ist, die Induktivität des Systems vom Abstand zur metallischen Karosserie abhängig. Eine Abweichung der Induktivität schlägt sich in der frequenzabhängigen Stromantwort nieder. Auch andere Parameter, wie zum Beispiel der Widerstand lassen sich so auswerten.

Um einen Vergleich der gemessenen Frequenzabhängigkeit der Stromamplitude mit einem Referenzverlauf zu ermöglichen, kann zum Beispiel eine Bandbreite, der Wert der Resonanzfrequenz oder der Gradient der Frequenzabhängigkeit des Stromverlaufs herangezogen werden.

Der Gütefaktor des schwingungsfähigen Systems ist einerseits proportional zu $\dfrac{1}{R} \times \sqrt{L/C}$ , wobei R der Wirkwiderstand, L die Induktivität und C die Kapazität darstellen. Andererseits entspricht der Gütefaktor dem Quotienten aus Resonanzfrequenz und Bandbreite, so dass die Bandbreite und die Resonanzfrequenz zum Rückschluss auf einzelne Parameter der Antennengeometrie, insbesondere auf die Induktivität, verwendet werden können. Als Bandbreite wird zum Beispiel die Differenz der Frequenzwerte verwendet, bei denen die Stromamplitude um eine bestimmte Dämpfung, zum Beispiel 3dB, abgefallen ist.

Eine erfindungsgemäße Treibereinrichtung weist eine Einrichtung zum Anlegen einer Spannung an die Antenne, ein Steuerelement zum Aufprägen einer Frequenz auf die angelegte Spannung, eine Steuerungseinrichtung, vorzugsweise einen Mikroprozessor, zur Änderung der aufgeprägten Frequenz, eine Messeinrichtung zur Messung des fließenden Stromes und eine Auswerteeinrichtung, vorzugsweise einen Mikroprozessor, zur Auswertung der Frequenzabhängigkeit der Amplitude des gemessenen Stromes auf. Mit einer erfindungsgemäßen Treibereinrichtung lässt sich das erfindungsgemäße Prüfverfahren durchführen.

Die Einrichtung zum Anlegen einer Spannung und das Steuerelement können dabei einzelne Elemente sein, oder von einer entsprechend ausgestalteten Spannungsquelle als eine Einheit gebildet werden, die eine Spannung mit einer aufgeprägten Frequenz zur Verfügung stellt.

Besonders vorteilhaft und einfach im Aufbau ist es, wenn die Steuereinrichtung und die Auswerteeinrichtung von einer gemeinsamen Steuer- und Auswerteeinrichtung gebildet werden, vorzugsweise von einem gemeinsamen Mikroprozessor.

Um zum Beispiel eine Auswertung durch Vergleich mit einer Referenzfrequenzabhängigkeit oder einem Referenzparameter zu ermöglichen, weist die Auswerteeinrichtung vorteilhafterweise einen Vergleicher auf.

Ein entsprechender Vergleicher kann auch vorgesehen sein, eine gemessene Frequenzabhängigkeit der Stromamplitude für eine Antenne mit einer zuvor gemessenen Frequenzabhängigkeit der Stromamplitude einer anderen Antenne zu vergleichen.

Eine erfindungsgemäße Antenneneinrichtung weist eine Antenne und eine erfindungsgemäße Treibereinrichtung auf.

Besonders vorteilhaft ist die Verwendung einer erfindungsgemäßen Treibereinrichtung, einer erfindungsgemäßen Antenneneinrichtung oder eines erfindungsgemäßen Verfahrens bei sogenannten schlüssellosen Anwendungen im Kraftfahrzeugbereich (keyless car applications). Es kann damit auf einfache Weise die sichere und korrekte Funktionsfähigkeit der Antenne überprüft werden, um große Verlässlichkeit bei derartigen sicherheitsrelevanten Anwendungen zu gewährleisten.

Das erfindungsgemäße Verfahren bzw. die erfindungsgemäße Treibereinrichtung können derart ausgelegt und zum Beispiel im Kraftfahrzeug integriert sein, dass vor jeder Verwendung der Antenne automatisch eine Überprüfung durchgeführt wird. Ebenso kann eine Treibereinrichtung als externes Prüfgerät ausgelegt sein, um zum Beispiel bei einer Wartung an die Antenne angeschlossen zu werden und deren Funktionsfähigkeit oder Einstellung, insbesondere ihre Lage, zu überprüfen.

Die Erfindung wird anhand der in den beiliegenden schematischen Figuren dargestellten Ausgestaltungen im Detail erläutert.

Dabei zeigt:

Fig. 1 den Schaltplan einer Ausführungsform einer erfindungsgemäßen Treibereinrichtung zur Durchführung eines erfindungsgemäßen Verfahrens,

Fig. 2 den Schaltplan einer zweiten Ausführungsform einer erfindungsgemäßen Treibereinrichtung zur Durchführung eines erfindungsgemäßen Verfahrens,

Fig. 3 den Schaltplan einer dritten Ausführungsform einer erfindungsgemäßen Treibereinrichtung zur Durchführung eines erfindungsgemäßen Verfahrens, und

Fig. 4 Beispiele für die Frequenzabhängigkeit der Amplitude des Stromes.

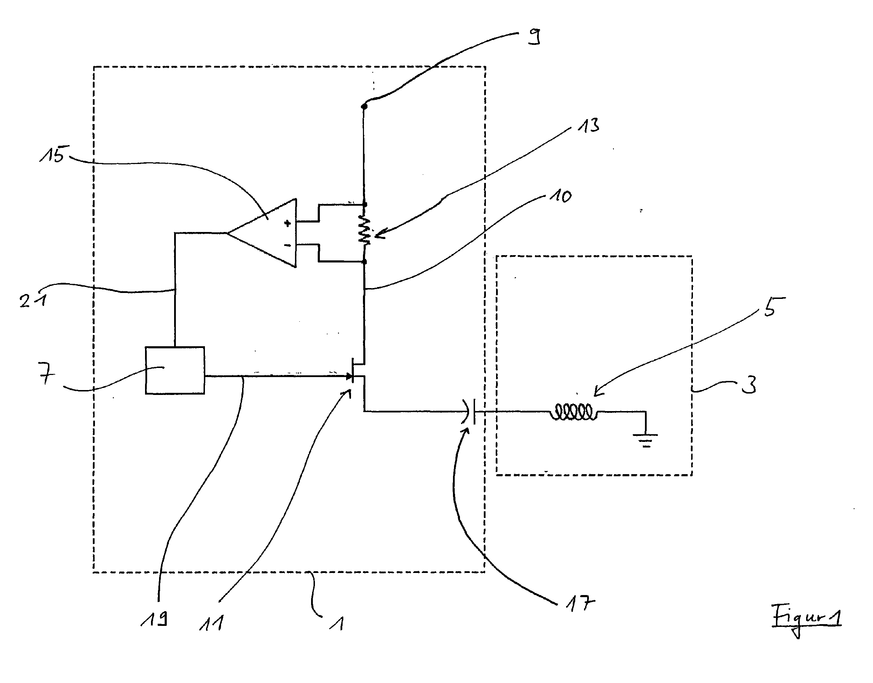

Fig. 1 zeigt eine mögliche Treibereinrichtung in Form einer schematisch dargestellten Treiberschaltung 1 für eine Antenne 5, die im vorliegenden Beispiel spulenförmig dargestellt ist. Die Antenne befindet sich im dargestellten Beispiel innerhalb des Fahrzeuges 3 und ist über einen Kondensator 17 mit der Treiberschaltung 1 verbunden. Am Anschluss 9 der Treiberschaltung wird eine Batteriespannung, zum Beispiel der Fahrzeugbatterie, angelegt. Ein Mikroprozessor 7, dessen Ausgangsleitung 19 mit dem Gate eines Feldeffekttransistors 11 verbunden ist, prägt dem durch die Spannung hervorgerufenen Strom durch die Leitung 10 eine Frequenz auf, zum Beispiel mit Hilfe einer mit einer bestimmten Frequenz durchgeführten Schaltung des Feldeffekttransistors 11. In der Leitung 10 befindet sich ein Widerstand 13, an dem der durch den Stromfluss bewirkte Spannungsabfall von dem Operationsverstärker 15 abgegriffen wird. Der Ausgang des Operationsverstärkers 15 wird über die Signalleitung 21 an den Mikroprozessor 7 geliefert.

Eine solche Ausführungsform kann wie folgt zur Prüfung der Antenne eingesetzt werden. Die Batteriespannung wird an den Anschluss 9 angelegt. Der Stromfluss durch die Leitung 10 wird mit Hilfe des Feldeffekttransistors 11 gesteuert. Dazu gibt der Mikroprozessor 7 an das Gate des Feldeffekttransistors 11 ein entsprechendes Taktsignal, zum Beispiel zum Öffnen bzw. Schließen des Transistordurchflusses im Takt der anliegenden Frequenz. Der so erzeugte wechselnde Strom wird durch die Antenne 5 geschickt, mit Hilfe des Widerstandes 13 und dem Operationsverstärker 15 gemessen und als Messsignal an den Mikroprozessor 7 weitergegeben.

Der Mikroprozessor 7 ändert die Frequenz zum Beispiel selbsttätig oder durch Einstellung durch einen Benutzer. Durch die Änderung der Frequenz ist es möglich, die Frequenzabhängigkeit der Stromamplitude zu bestimmen, die dann mit einer Referenzfrequenzabhängigkeit verglichen wird, die in einem dem Mikroprozessor zugeordneten Speicher abgelegt ist. Dazu kann zum Beispiel die Form, der Gradient, die Resonanzfrequenz und/oder die Bandbreite der Frequenzabhängigkeit der Stromamplitude ausgewertet werden. Wie oben ausgeführt lässt sich aus der Bandbreite und der Resonanzfrequenz insbesondere auf die Induktivität des Systems zurückschließen.

Ändert sich zum Beispiel die Lage der Antenne mit Bezug zur Karosserie, so ändert sich auch die Induktivität des Systems und damit die Frequenzabhängigkeit der Stromamplitude. Ähnliches gilt, wenn an der Antenne unberechtigte Manipulationen vorgenommen worden wären oder die Zuleitung zur Antenne oder die Antenne selbst unterbrochen wären.

Abweichungen vom frequenzabhängigen Signalverlauf können zum Auslösen einer Warnung verwendet werden. Andererseits kann der Signalverlauf auch verwendet werden, um den eingespeisten Strom derart zu variieren, dass ein gewünschtes Magnetfeld erzeugt wird.

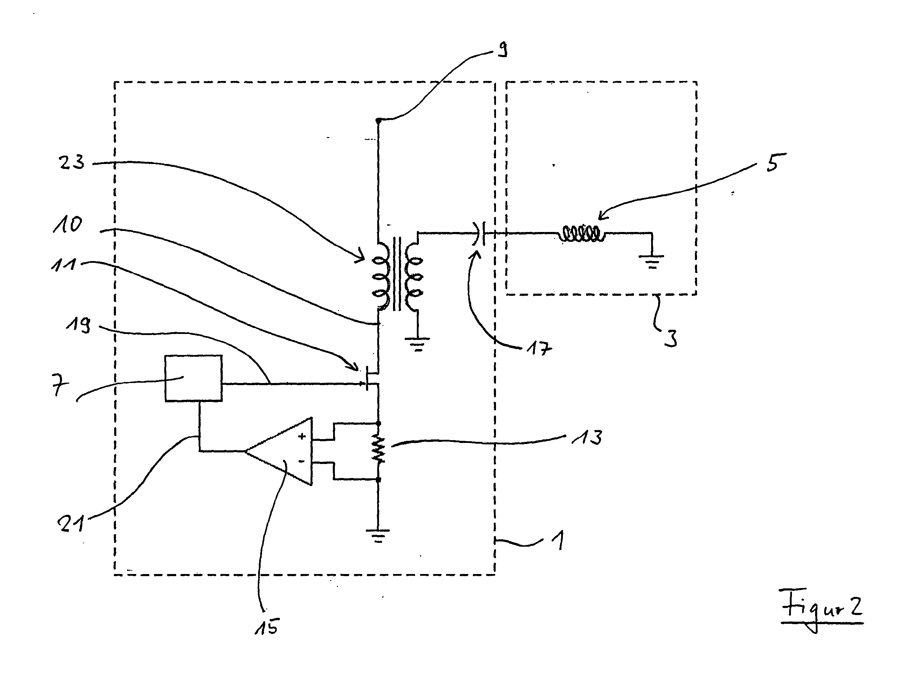

Die Ausführungsform der Fig. 2 unterscheidet sich von der Ausführungsform der Fig. 1 durch einen zusätzlichen Transformator, der zur Entkopplung bzw. zum Herauf- bzw. Heruntertransformieren des Stromes dient. Außerdem ist in Fig. 2 eine Ausführungsform dargestellt, bei der der Strom der Leitung 10 auf der anderen Seite des Feldeffekttransistors 11 gemessen wird.

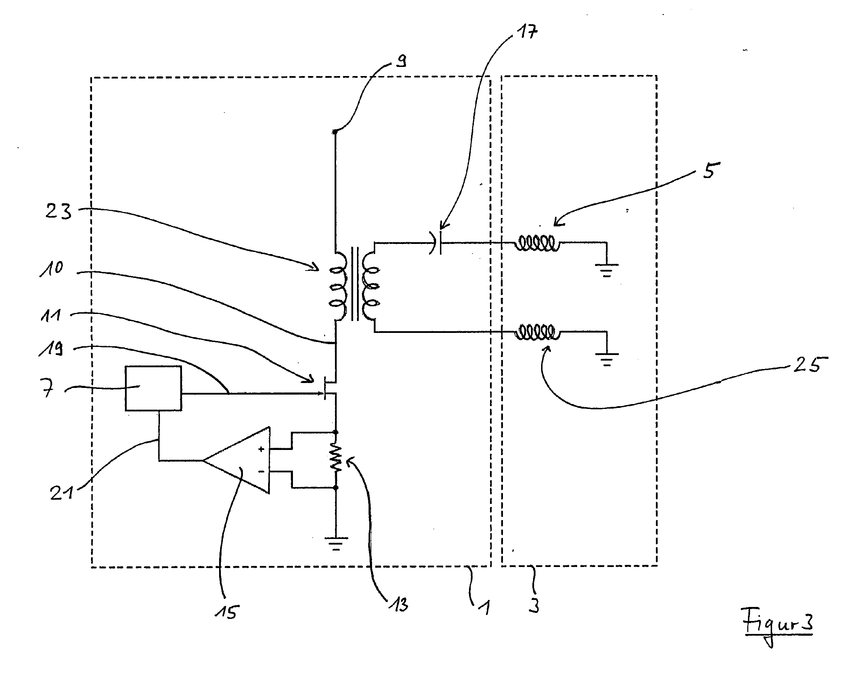

Fig. 3 zeigt eine Ausführungsform, bei der zwei Antennen 5, 25 mit der Treiberschaltung 1 verbunden sind. In einem solchen Fall wird ein Fehler oder eine Abweichung der gesamten Antennengeometrie mit den zwei Antennen von einem im Vorhinein bestimmten Referenzverlauf analysiert.

Einzelne Merkmale der Figuren 1 bis 3 können miteinander kombiniert werden.

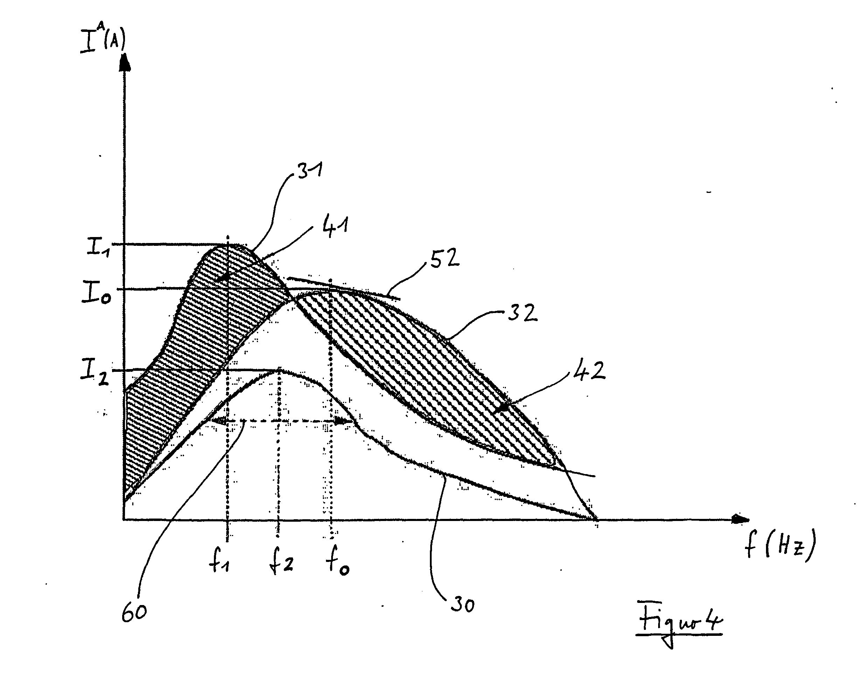

Fig. 4 zeigt die Abhängigkeit der Stromamplitude $I^A$ des Stromes (aufgetragen in Ampere), der bei den gezeigten Ausführungsformen am Widerstand 13 gemessen wird, von der Frequenz f (aufgetragen in Hertz), die von dem Mikroprozessor 7 mit Hilfe des Feldeffekttransistors 11 aufgeprägt wird. Bezugsziffer 32 zeigt dabei einen typischen Signalverlauf, wie er als Referenz verwendet werden kann. Das Maximum bei der Resonanzfrequenz $f_0$ ist mit $I_0$ bezeichnet. 31 bezeichnet ein Beispiel einer Abhängigkeit der Stromamplitude von der Frequenz für eine manipulierte, geänderte oder fehlerhafte Antennengeometrie. Die Resonanzfrequenz ist zu $f_1$ verschoben und das Maximum der Stromamplitude liegt bei $I_1$. Die Differenz der gemessenen Kurve 31 und der Referenzkurve 32 ist in Fig. 4 durch die Flächen 41 bzw. 42 dargestellt.

Dabei ergeben sich beim dargestellten Beispiel gleiche Abhängigkeiten des gemessenen Verlaufes 31 und des Referenzverlaufes 32 nur in den Schnittpunkten der Kurven 31 und 32. Ebenso sind jedoch Fälle denkbar, bei denen sich identische Kurvenverläufe in größeren Frequenzbereichen ergeben.

Deutlich ist erkennbar, dass das erfindungsgemäße Verfahren gerade in einem solchen Fall einen Vorteil mit sich bringt, da durch die Auswertung bei unterschiedlichen Frequenzen auf jeden Fall eine Abweichung der Kurven 31 und 32 festgestellt werden kann.

Bei Messverfahren, bei denen die Stromamplitude nur bei einer Frequenz ausgewertet wird, würden zum Beispiel Lageabweichungen nicht festgestellt werden können, wenn die ausgewählte Messfrequenz in einen Bereich oder an einem Punkt der Frequenzabhängigkeit der Stromamplitude liegen würde, in dem die gemessene Stromamplitude der Stromamplitude des Referenzverlaufes bei der ausgewählten Frequenz entspricht.

Analog zeigt Kurve 30 einen auf andere Weise abweichenden Verlauf der Stromamplitude $I^A$ in Abhängigkeit der Frequenz f. Das Maximum, das hier bei der Frequenz $f_2$ liegt, hat den Wert $I_2$.

Unterschiedliche Parameter können zur Auswertung und zum Vergleich mit der Referenzkurve 32 verwendet werden. Beispielhaft wurde für den Referenzverlauf 32 der Gradient 52 bei einer bestimmten Frequenz eingezeichnet. Der Verlauf des Gradienten bzw. der Gradient bei einer oder mehreren ausgewählten Frequenzen für die gemessenen Verläufe (zum Beispiel die Verläufe 30, 31) kann mit den entsprechenden Werten der Referenzkurve 32 verglichen werden und so eine Abweichung detektiert werden.

Am Beispiel des Verlaufes 30 wurde die Bandbreite 60 eingezeichnet, aus der zusammen mit der Resonanzfrequenz $f_2$ auf die Induktivität geschlossen werden kann.

Das erfindungsgemäße Verfahren kann auch verwendet werden, um Abweichungen zweier nominal gleicher Antennen feststellen zu können, die zum Beispiel durch unterschiedliche Lagen der Antennendrähte im jeweiligen Fahrzeug hervorgerufen werden können. So kann sich zum Beispiel bei Messung der frequenzabhängigen Stromamplitude einer ersten Antenne eine Messkurve ähnlich der Kurve 31 ergeben und bei Messung der frequenzabhängigen Stromamplitude einer zweiten Antenne eine Messkurve ähnlich der Kurve 30.

Das erfindungsgemäße Verfahren und die erfindungsgemäße Treibereinrichtung ermöglichen also die Prüfung einer Antenne bzw. den Vergleich einer Antenne mit einer zweiten Antenne oder einer Referenzantenne mit einer hohen Verlässlichkeit.

**Bezugszeichenliste**

| | |
|---|---|
| 1 | Treiberschaltung |
| 3 | Fahrzeug |
| 5 | Antenne |
| 7 | Mikroprozessor |
| 9 | Batterieanschluss |
| 10 | Stromleitung |
| 11 | Feldeffekttransistor |
| 13 | Widerstand |

| 15 | Operationsverstärker |
| 17 | Kondensator |
| 19 | Mikroprozessorausgang |
| 21 | Mikroprozessoreingang |
| 23 | Transformator |
| 25 | Antenne |
| 30, 31 | Beispiele für Messkurven |
| 32 | Referenzkurve |
| 41, 42 | Abweichungen |
| 52 | Gradient |
| 60 | Bandbreite |

**Patentansprüche**

1. Prüfverfahren für eine Antenne, insbesondere für eine Antenne zur Erzeugung eines Magnetfeldes, bei dem

- eine Spannung mit variierender Frequenz an die Antenne (5, 25) angelegt wird,
- die Frequenzabhängigkeit der Amplitude ($I^A$) des in Antwort darauf fließenden Stromes gemessen wird, und
- zur Feststellung der Funktionstüchtigkeit und/oder der Lage und/oder des Aufbaus der Antenne (5, 25) die Frequenzabhängigkeit der Amplitude ($I^A$) des Stromes oder wenigstens ein daraus abgeleiteter Parameter ausgewertet wird.

2. Prüfverfahren nach Anspruch 1, bei dem zur Auswertung die gemessene Frequenzabhängigkeit mit einer Referenzfrequenzabhängigkeit oder ein aus der gemessenen Frequenzabhängigkeit abgeleiteter Parameterwert mit einem entsprechenden Referenzwert verglichen wird.

3. Prüfverfahren nach einem der Ansprüche 1 oder 2, bei dem der Wert der Resonanzfrequenz ($f_0$, $f_1$, $f_2$) und/oder der Gradient (52) ausgewertet wird.

4. Prüfverfahren nach Anspruch 1 bis 3, bei dem eine Breite (60), vorzugsweise die Bandbreite, der Frequenzabhängigkeit der Amplitude ($I^A$) des Stromes ausgewertet wird.

5. Prüfverfahren nach einem der Ansprüche 1 bis 4, bei dem Information über die Induktivität der Antenne ausgewertet wird, die aus der Frequenzabhängigkeit der Amplitude ($I^A$) des Stromes abgeleitet wird.

6. Prüfverfahren nach den Ansprüchen 4 und 5, bei dem eine Breite der Frequenzabhängigkeit der Amplitude ($I^A$) des Stromes, vorzugsweise die Bandbreite, verwendet wird, um auf die Induktivität der Antenne (5, 25) zurück zu schließen.

7. Treibereinrichtung für eine Antenne, insbesondere für eine Antenne zur Erzeugung eines Magnetfeldes, zur Durchführung eines Verfahrens nach einem der Ansprüche 1 bis 6, mit

- einer Einrichtung zum Anlegen einer Spannung an die Antenne (5, 25),
- einem Steuerelement (11) zum Aufprägen einer Frequenz auf die angelegte Spannung,
- einer Steuerungseinrichtung (7), vorzugsweise einem Mikroprozessor, zur Änderung der aufgeprägten Frequenz,
- einer Messeinrichtung (13, 15) zur Messung des fließenden Stromes und
- einer Auswerteeinrichtung (7), vorzugsweise einem Mikroprozessor, zur Auswertung der Frequenzabhängigkeit der Amplitude ($I^A$) des gemessenen Stromes.

8. Treibereinrichtung nach Anspruch 7, bei der die Steuereinrichtung und die Auswerteeinrichtung von einer gemeinsamen Steuer- und Auswerteeinrichtung (7), vorzugsweise einem Mikroprozessor, gebildet werden.

9. Treibereinrichtung nach einem der Ansprüche 7 oder 8, bei der das Steuerelement einen Transistor (11) umfasst, dessen Gate mit dem Ausgang (19) der Steuereinrichtung (7) verbunden ist.

10. Treibereinrichtung nach einem der Ansprüche 7 bis 9, bei der die Messeinrichtung einen Widerstand (13) und einen Spannungsaufnehmer, vorzugsweise einen Operationsverstärker (15), zur Messung der über dem Widerstand (13) abfallenden Spannung umfasst, dessen Ausgang (21) mit dem Eingang der Auswerteeinrichtung (7) verbunden ist.

11. Treibereinrichtung nach einem der Ansprüche 7 bis 10, bei der die Auswerteeinrichtung (7) über einen Vergleicher verfügt, der die Frequenzabhängigkeit der Amplitude ($I^A$) des gemessenen Stromes bzw. einen daraus abgeleiteten Parameter mit einer Referenzfrequenzabhängigkeit bzw. einem Referenzparameter vergleicht.

12. Antenneneinrichtung mit wenigstens einer Antenne (5, 25) und einer Treibereinrichtung (1) nach einem der Ansprüche 7 bis 11.

13. Verwendung einer Treibereinrichtung (1) nach einem der Ansprüche 7 bis 11, einer Antenneneinrichtung nach Anspruch 12 oder eines Verfahrens nach einem der Ansprüche 1 bis 6 für ein drahtloses Zugangs- und/oder Berechtigungssystem, insbesondere bei Kraftfahrzeugen.

Figur 1

Figur 2

Figur 3

Figur 4

**Europäisches Patentamt**

**EUROPÄISCHER RECHERCHENBERICHT**

Nummer der Anmeldung

EP 05 02 2703

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2002/157070 A1 (EMBLING STEVEN ET AL) 24. Oktober 2002 (2002-10-24) * Zusammenfassung; Abbildungen 1,4 * * Absatz [0036] - Absatz [0058] * ----- | 1-13 | G01R29/10 G01R31/28 B60R25/00 |
| A | DE 196 02 316 C1 (SIEMENS AG, 80333 MUENCHEN, DE) 19. Juni 1997 (1997-06-19) * Zusammenfassung; Abbildungen 1-3 * * Spalte 1, Zeile 3 - Zeile 31 * * Spalte 1, Zeile 56 - Spalte 5, Zeile 44 * ----- | 1-13 | |
| X | ANONYMOUS: "Interpreting Antenna Performance Parameters for EMC Applications"[Online] 14. Oktober 2003 (2003-10-14), XP002373718 Gefunden im Internet: URL:http://djmelectronics.com/articles/emc -antenna-parameters-p1.html> [gefunden am 2006-03-22] * das ganze Dokument * ----- | 1-12 | |
| A,D | EP 1 454 807 A (DELPHI TECHNOLOGIES, INC) 8. September 2004 (2004-09-08) * Zusammenfassung; Abbildung * ----- | 1-13 | **RECHERCHIERTE SACHGEBIETE (IPC)** G01R B60R H01Q H04B |
| A,D | DE 198 20 207 A1 (SIEMENS AG) 25. November 1999 (1999-11-25) * Zusammenfassung; Abbildung 1 * ----- | 1-13 | |
| A | EP 1 548 871 A (DELPHI TECHNOLOGIES, INC) 29. Juni 2005 (2005-06-29) * Zusammenfassung; Abbildung 1 * ----- | 13 | |

-/--

Der vorliegende Recherchenbericht wurde für alle Patentansprüche erstellt

| Recherchenort | Abschlußdatum der Recherche | Prüfer |
|---|---|---|
| Berlin | 23. März 2006 | Ernst, M |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**Europäisches**
**Patentamt**

# EUROPÄISCHER RECHERCHENBERICHT

Nummer der Anmeldung

EP 05 02 2703

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 197 35 282 C1 (SEKURIT SAINT-GOBAIN DEUTSCHLAND GMBH & CO. KG, 52066 AACHEN, DE) 25. Februar 1999 (1999-02-25) * Zusammenfassung; Abbildungen 2,3 * * Spalte 2, Zeile 61 - Spalte 3, Zeile 56 * ----- | 1-12 | |

RECHERCHIERTE SACHGEBIETE (IPC)

Der vorliegende Recherchenbericht wurde für alle Patentansprüche erstellt

| Recherchenort | Abschlußdatum der Recherche | Prüfer |
|---|---|---|
| Berlin | 23. März 2006 | Ernst, M |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
.....................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 05 02 2703

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

23-03-2006

| Im Recherchenbericht angeführtes Patentdokument | Datum der Veröffentlichung | Mitglied(er) der Patentfamilie | Datum der Veröffentlichung |
|---|---|---|---|
| US 2002157070 A1 | 24-10-2002 | KEINE | |
| DE 19602316 C1 | 19-06-1997 | FR 2743962 A1<br>GB 2309605 A | 25-07-1997<br>30-07-1997 |
| EP 1454807 A | 08-09-2004 | DE 10309600 A1 | 16-09-2004 |
| DE 19820207 A1 | 25-11-1999 | FR 2778464 A1 | 12-11-1999 |
| EP 1548871 A | 29-06-2005 | KEINE | |
| DE 19735282 C1 | 25-02-1999 | KEINE | |

EPO FORM P0461

Für nähere Einzelheiten zu diesem Anhang : siehe Amtsblatt des Europäischen Patentamts, Nr.12/82

**EP 1 777 532 A1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1454807 A1

- DE 19820207 A1